(19) Europäisches Patentamt
European Patent Office
Office européen des brevets

(11) **EP 4 131 759 A1**

(12) **EUROPEAN PATENT APPLICATION**

(43) Date of publication:
08.02.2023 Bulletin 2023/06

(21) Application number: 21189457.1

(22) Date of filing: 03.08.2021

(51) International Patent Classification (IPC):
*H02M 3/00* (1968.09)     *H02M 7/00* (1968.09)

(52) Cooperative Patent Classification (CPC):
**H02M 3/003; H01L 23/4093; H02M 7/003;
H05K 1/0206; H05K 1/0265;** H05K 3/0061;
H05K 2201/066; H05K 2201/0792;
H05K 2201/09609; H05K 2201/10015;
H05K 2201/10166; H05K 2201/10598;
H05K 2201/10606

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Watt & Well**
**84120 Pertuis (FR)**

(72) Inventors:
• **SAKR, Nadim**
  **91300 Massy (FR)**
• **IGLESIAS, Raul**
  **92160 Antony (FR)**
• **BIDAUT, Benjamin**
  **13090 Aix-en-Provence (FR)**

(74) Representative: **Schmidt, Martin Peter**
**IXAS Conseil
22 avenue René Cassin
69009 Lyon (FR)**

(54) **HIGHLY INTEGRATED MOSFET HALF-BRIDGE POWER MODULE FOR POWER CONVERTERS**

(57)     A multiple layer PCB power board (10) comprising at least one two-switch leg structure comprising power switching components (14) and associated driving circuits, characterised in that said board is configured such that the current flows from a top layer to a bottom layer, to minimize power-loop inductance.

Said PCB power board (10) has a bottom side provided with a flat portion for connecttion to a flat thermal pad (32) which is part of said heat sink (50).

**Fig. 1**

EP 4 131 759 A1

**Description**

**Technical field of the invention**

The present disclosure relates to electrical engineering, and more precisely to power converters. It relates in particular to grid tied power converters and is particularly useful for electric-vehicle (EV) battery chargers and other grid tied chargers that carry high power densities and dissipate significant amounts of heat.

**Background of the invention**

The widespread use of electrical vehicles has triggered an increasing need for grid tied power converters that can carry high currents. As miniaturization of power supplies and chargers is desirable, power density has become an important factor when designing power converters. High operating frequency helps the miniaturization since it allows size reduction in the passive components of the system. Therefore, the use of fast power switching devices such as SiC MOSFETs or GaN power switches is essential. These switches accomodate higher frequency operation with low power losses. They usually operate at voltages comprised between several tens of volts up to a few kilovolts.

According to the state of the art, power converters are formed by several two-switch leg structures also known as « half-bridge » or « inverter/rectifier leg ». For fast prototyping and to allow scalable power converters, designing and optimizing these half bridge power legs is a key issue.

In designing PCB boards for fast power switching applications, there are two main concerns: parasitic inductances and heat dissipation.

One of the main concerns is reducing the parasitic inductance of the switching cell, since this inductance causes voltage ringing, voltage stress on the devices and high electro-magnetic interference (EMI) during switching.

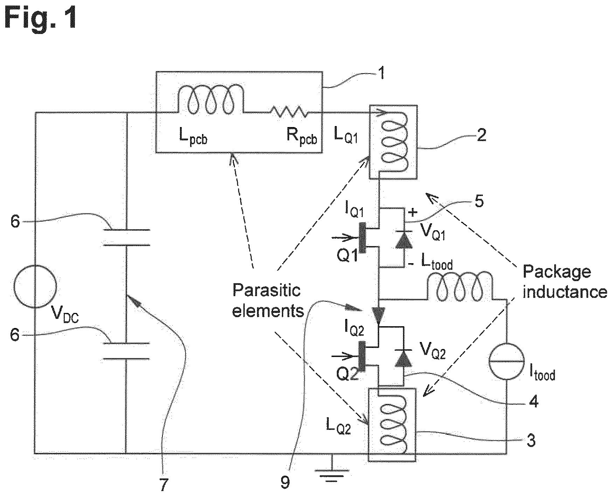

As schematically shown on figure 1, the main parasitic elements which influence the ringing process are the inductance of the PCB loop **1** and the inductances of the switch packages **2,3**. The stray inductance is the sum of all these inductances. The power loop inductance forms an LC resonant circuit with the MOSFET parasitic output capacitance and the drain-ground parasitic capacitance (not shown on figure 1). The induced ringing voltage may produce an overvoltage between drain and source that can damage the transistor. Therefore, the power loop inductance should be kept as low as possible. Reference number **9** designates the midpoint between the low side switch **4** and the high side switch **5.**

Through hole (TH) switching components like TO-220 or TO-247 (these standard desogbaitons are known to a person skilled in the art) have high package parasitic inductance which can reach up to 15 nH or more. To reduce the overall loop inductance, surface mounted devices (SMD) are preferred. They have low package inductance between **1** nH to 5 nH, at least three times lower than traditional TH devices.

The selection of an appropriate Printed Circuit Board (PCB) material is also important since it allows to evacuate the heat generated by the power switches. FR4 PCBs and Insulated Metal Substrate (IMS) boards are most suited for this type of application. FR4 is a standard designation defined by NEMA (National Electrical Manufacturer Association) for a glass fiber reinforced epoxy resin bord which is flame retardant (FR).

In the market today, SMD half bridge boards can be found using vertically mounted FR4 PCBs or horizontally mounted IMS boards. The publication « Modular approach to power electronics » by Urban Medic (White Paper 03-2019 by Infineon, available from https://www.infineon.com/cms/en/applications/consumer/light-vehicles/light-electric-vehicles/) describes various geometries using horizontal power boards connected to a vertical mother master board and possibly to additional vertical daughter boards.

These architectures exhibit two main problems: the connexion between the different boards, and heat dissipation. When using one-layer IMS boards, the MOSFET's drivers are on a separate PCB board. The backside of the IMS board being flat, can be fixed to a cold plate (or heat sink). However, the thermal contact between the board and the cold plate must be maximized and the thermal resistance must be reduced. This can be achieved using a number of mounting holes spread symmetrically across the IMS board. The effectiveness of this solution is not always guaranteed due to the high creepage distances required. Reducing the numbers of screws would reduce the mounting screw downforce and therefore would increase the thermal resistance to ambient which makes heat disspiation less effective. Moreover, it requires thermal grease to be applied homogeneously between the board and the cold plate; this is not easy to achieve in industrial production. And at last, the surface occupied on the board by said mounting holes must be provided for when designing the board; this may be a problem as these boards need to be miniaturized.

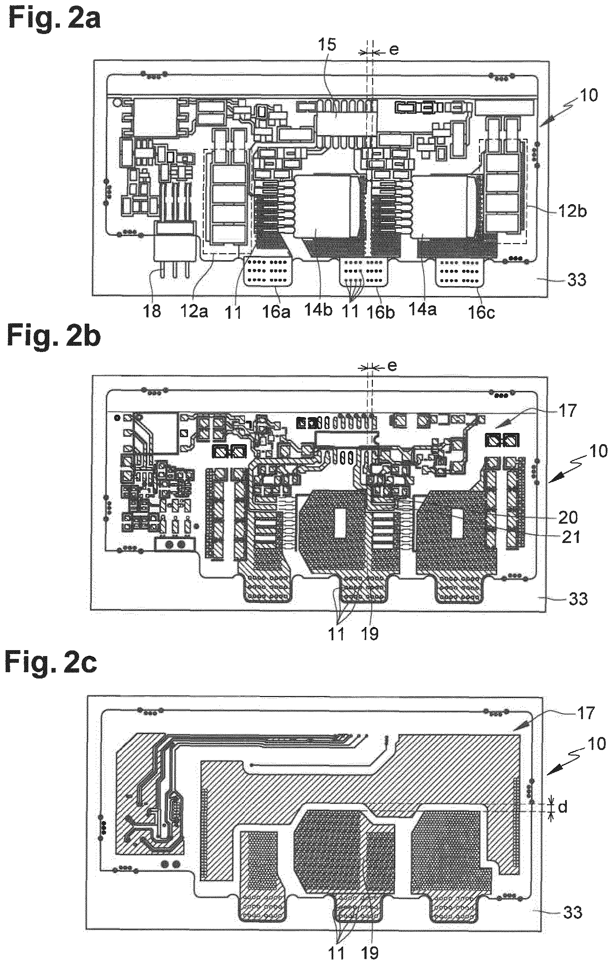

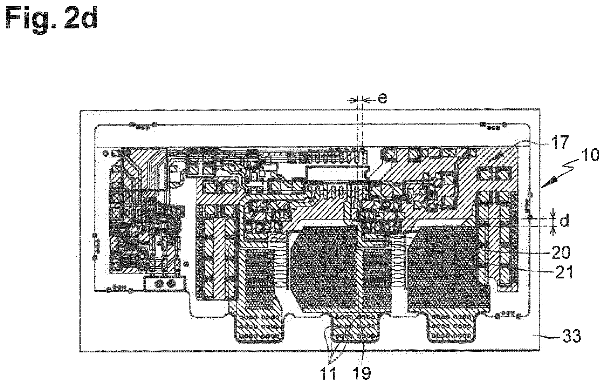

As an alternative it has been proposed to fix a heat sink directly on a double sided adhesive tape (so-called TIM, Thermal Interface Material); however, as said adhesive tape must be electrically insulating, this creates a thermal barrier. This solution, described in a publication from Texas Instruments « Using the LMG3410-HB-EVM Half-Bridge and LMG34XX-BB-EVM Breakout Board EVM - General TI High Voltage Evaluation User Safety Guidelines » (SNOU140A-April 2016 - Revised May 2017, available from https://www.ti.com/tool/LMG3410-HB-EVM, see figure 2), has two disadvantages: this solution is not suited for big SMD packages like TO-263-7, and anyway, the size and heat dissipation of such a heat sink is usually rather limited. It should be borne in mind that heat is generated mainly by the power MOSFETs, which represent hot spots on the PCB, but as heat generated by the MOSFETs will end up dissipating into the PCB, eventually the whole PCB will require cooling.

It would be possible to inscrease the thermal contact between the fast power switching components and the heat sink by applying pressure on the TIM by using screws; this would allow to use a customized heat sink. However, this solution increases the assembly complexity and inceases the system cost. In addition, tightening screws would be placed far from the MOSFETS, and therefore pressure would not be applied equally in the board's surface, leading to uneven thermal behavior on the PCB's surface.

The present invention tries to find a solution that allows to have fast power switching components such as MOSFETs and associated drivers on the same PCB, and that allows efficient heat dissipation when large package MOSFETs are used. This solution should also allow a decrease in power loop inductance. This solution should be simple and inexpensive, too, both for material cost and mounting cost.

## Summary of the invention

The present invention is about a power switching device comprising at least one fast switching component. The term fast switching component or fast switiching device referes herein, respetively, to components such as SiC MOSFETs or GaN power switches, and to devices incorporating such components. The fast switching device accommodates higher frequency operation with low losses. An implementation of a power switching device is a power convertor. Power converters are formed by several two-switch leg structure also known as "half-bridge" or "inverter/rectifier leg".

One technical problem dealt with by the present disclosure is how to cool a PCB power board and how to provide thermal contact between the fast power switching device and the heat sink.

According to the invention the problem is solved by a combination of means, as will be explained hereinbelow.

According to an essential feature of the invention, the PCB power board is either a single-sided PCB power board having a flat side, called here "back side", containing no surface mounted components, and a front side comprising electronic components among which one or more power switches, or a double-sided PCB power board of which a substantial portion of its flat back side contains no surface mounted components. Said portion with no surface mounted components is called here the "free portion" of the backside. Said free portion is advantageously at least 30 % of the toal surface of backside, advantageously at least 50 %, and more advantageously at least 70 %; this is the meaning of "substantial" in the context above.

According to another essential feature of the invention, the back side of said PCB power board, or at least its free portion, is directly fixed onto a flat portion of a heat sink. This ensures excellent thermal contact. Said heat sink is typically provided with cooling fins. Such heat sinks can be made from extruded aluminium parts, the flat portion being possibly machined and/or polished for optimum thermal contact.

According to an advantageous embodiment of the invention, the PCB power board is a single-sided PCB power board. It can be fixed to a flat portion of a heats sink, sait flat portion of the heat sink having a size and surface at least equal to that of the backside of the PCB power board. This direct fixation of the backside of the PCB power board to a flat portion of the heat sink of a size at least comparable to that of the PCB power board is possible because a single-sided PCB power board is used.

According to an advantageous embodiment, the soldermask from the back side of the board underneath the power switching devices is removed for effective heat removal.

According to another advantageous embodiment that can be combined with any of the other ones described here, said free portion of the backside of said PCB power board is opposite to at least one fast switching component provided on the front side. A plurality of vias can be provided underneath said at east one fast switching component, thereby fostering direct heat transfer accross the thickness of the PCB board into the flat portion of the heat sink.

In order to achieve good thermal contact between the fast switching components that generate the heat to be dissipated and the heat sink, one technical solution is pressing the PCB power board to the heat sink and applying equal and adequate compression force for providing the thermal contact without using screws. Due to the small size of the two-layers PCB power board, it is highly integrated and there is no space for screws.

According to another feature of the invention, the PCB is fixed to said heat sink by at least one elastic retaining clip. Preferably, said elastic retaining clip exerts pressure on the surface of the fast switching components, and still more preferably, one clip is used for each fast switching component used on the PCB board.

Another technical problem dealt with by the present disclosure is how to reduce the parasitic inductance of the fast switching component. Such inductance causes voltage ringing, voltage stress on the devices and high electromagnetic interference (EMI) during switching. The main parasitic elements of a PCB fast switching device which influence the ringing process are the inductance of the PCB loop and the inductances of the switches' package. Therefore, power loop inductance should be kept as low as possible.

According to another essential feature of the invention this is achieved by using a multiple layer PCB power board which is designed to reduce the loop of the current that flows from a first layer to a second layer of the board and, thus, to reduce the induced magnetic field. Said PCB has at least two conductive layers.

A first object of the present invention is a mulitple layer PCB power board comprising at least one two-switch leg structure comprising power switching components and associated driving circuits, characterised in that said board is configured such that the current flows from a top layer to a bottom layer, to minimize power-loop inductance.

Said power switching components are in parallel with capacitors; these are preferably ceramic capacitors.

More precisely, according to an advantageous embodiment, the PCB comprises a switch leg structure characterized in that the return power path is placed on a different layer of said at least two layers to minimize power-loop inductance. In an advantageous embodiment said multiple layer PCB board is a two-layer PCB board with a conductive top layer and a conductive bottom layer separated by an insulating layer, said two-layer PCB board having a top-bottom power path, the bottom layer being used for the return current. In an advantageous embodiment the thickness of the PCB is of the order of about 0.8 mm; the thickness of each of the conductive layers is typically of the order of 50 μm to 100 μm.

To reduce the PCB loop inductance, it is advangeous to position the ceramic capacitors as close as possible to the DC bus of the fast switching component.

According to another feature of the invention, in the PCB power board a large number of thermal vias is provided under each of the fast power switching component, and preferably additional thermal vias are provided at least in the vicinity of each switching device. They help drain the heat out of the board.

In some embodiments the two-layers PCB power board features vertical mount style which helps increasing power density of the converter.

In some embodiments the two-layers PCB power board is a daughter board connected to a main board via pins. In one example the two-layers PCB power board is connected to a main board via three power pins and/or 6-pins board connectors.

Such a two-layers PCB power board may require a single DC voltage input only (typically 5 V) and operates in bootstrap mode. Negative bias can also be generated through a Zener diode in the gate drive loop such that it only uses one power supply and requires the least cost and design effort. Such a two-layers PCB power board is advantageosuly a one side board.

In some embodiments the return power path of the two-layers PCB is placed on the bottom layer to minimize power-loop inductance. Due to thermal vias, the current return cannot perfectly mirror the current path located on the top layer; to still have the lowest loop inductance, the power devices are located as close together as possible and the DC bus capacitors are split into two equal groups positioned in line with the power devices. As can be seen on figure 1, the power devices are connected together at point **9.** In some advantageous embodiments according to the invention, they are separated by a distance e shown on figure 2a.

In some embodiments the midpoint net (point **7** on figure 1) connects the two sets of capacitors. The distance d between the midpoint and the power devices is minimized to be at least equal to the minimum creepage distance given by applicable standards for a maximum voltage value of DC bus voltage divided by 2. In an particularly advantageous embodiment, the distance *d* between the mid point of said capacitors and said power switching components is comprised between 1.1 mm and 2.5 mm, and preferably comprised between 1.1 mm and 2.0 mm, and still preferably between 1.1 mm and 1.5 mm, for a maximum DC bus voltage not exceeding 900 V. In another advantageous embodiment, which can also be combined with the one just mentioned, the distance e between the copper traces between two adjacent power switches is comprised between 1.0 mm and 3.0 mm, and preferably between 1.0 mm and 2.0 mm.

In some embodiments a thermal pad with high conductivity is placed at the bottom side of the PCB to help achieve the lowest possible thermal resistance and provide electrical insulation to the system.

Another object of the present invention is the use of a PCB power board according to the invention in a power conversion unit. In a particularly advangeous embodiment such power conversion unit is a battery charger for electrical vehicles. These chargers typically contain fast power switching devices that generate much heat and that generate high magnetic fields upon switching; according to the present invention, heat can be dissipated more efficiently, and magnetic fields induced by switching are reduced. According to an advantageous embodiment of the invention said fast power switching devices are provided on a multiple layer PCB power board, connected to the flat pad of a heat sink, preferably by means of at least one elastic retaining clip exerting mechanical pressure onto at least one of said power switching components, said mechanical pressure being directed towards said flat themal pad.

A final object of the present invention is a power conversion unit comprising at least one PCB board according to the invention. In such a power conversion unit, the PCB boards according of the invention are preferably daughter boards connected to a mother board containing components of the energy conversion unit that are more bulky.

**Brief description of the figures**

The present disclosed subject matter will be understood and appreciated more fully from the following detailed description taken in conjunction with the drawings in which corresponding or like numerals or characters indicate corresponding or like components. Unless indicated otherwise, the drawings provide exemplary embodiments or aspects of the disclosure and do not limit the scope of the disclosure.

Figure 1 is a general representation of the main parasitic elements of a half-bridge power module; it applies both to prior art and to the invention.

Figures 2 to 7 illustrate certain aspects of the present invention; they refer to specific embodiments and are not intended to limit the scope of the present invention.

Figure 2a shows a top view of the two-layers rectifier / inverter leg PCB power board, in accordance with some exemplary embodiments of the invention;

Figure 2b shows a schematic drawing of the top copper layer of the two-layers PCB power board of figure 2a;

Figure 2c shows a schematic drawing of the bottom copper layer of the two-layers PCB power board of figure 2a;

Figure 2d shows a superposition of figures 2b and 2c;

Figure 3 shows the elastic retaining clips in accordance with some exemplary embodiments of the invention;

Figure 4 shows a pespective view of two two-layers PCB power board fixed onto a heat sink, with the elastic retaining clips to be positioned, in accordance with some exemplary embodiments of the invention;

Figure 5 shows a front view of the same arrangement as figure 4, with the elastic retaining clips in place;

Figure 6 shows shows zoom view of the mounted clip in accordance with some exemplary embodiments of the invention; and

Figure 7 shows eight two-layers PCB power board fixed on mother board

Figures 8 to 10 illustrate embodiments which advantageously use multiple layer PCB boards according to the invention.

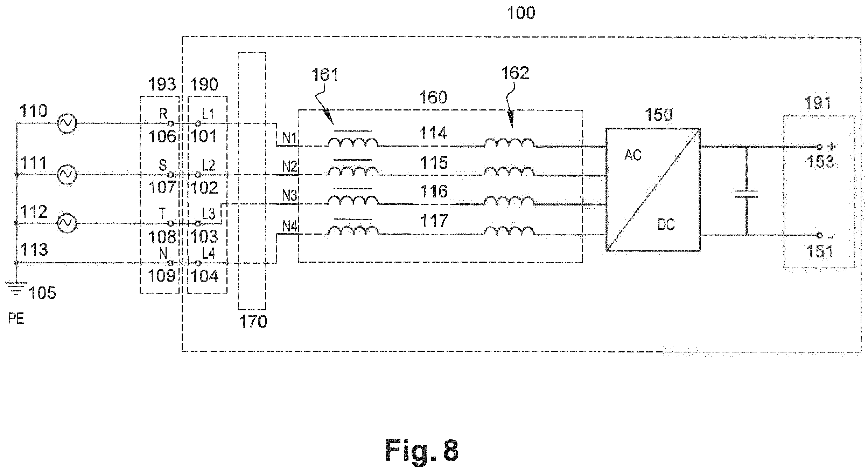

Figure 8 shows a universal and versatile charger for electric batteries of an electrical vehicle, configured as a charge in three-phase mode.

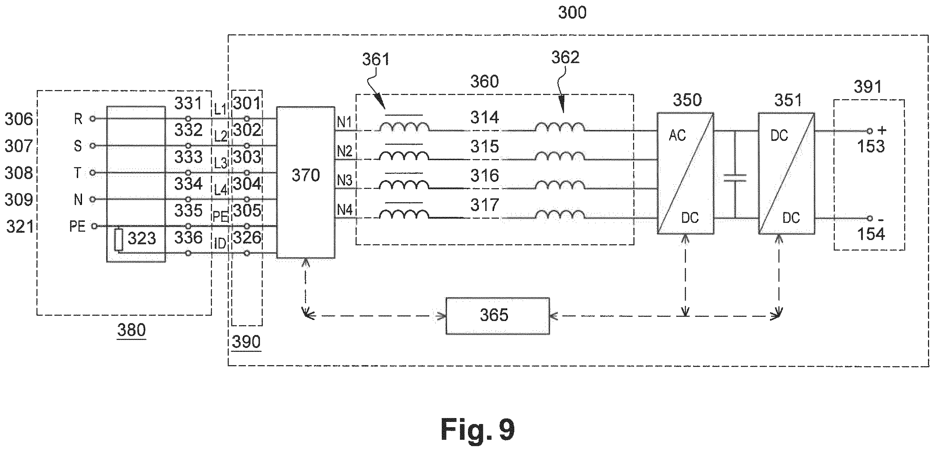

Figure 9 shows the same charger as in figure 8, configured in a four-phase mode.

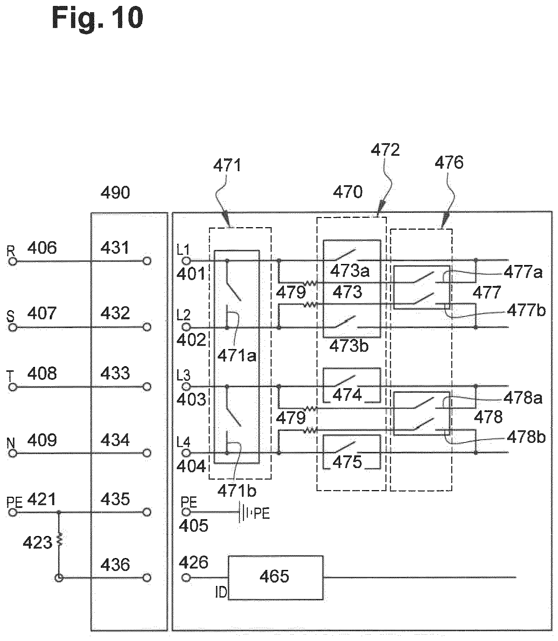

Figure 10 shows an ID configuration and detection system of the universal and versatile charger for electric batteries of an electrical vehicle similar to that of figure 8

The following reference numbers are used on the figures and in the description:

| | |
|---|---|
| 1 | PCB loop inductance |
| 2,3 | Switch parasitic inductance |
| 4,5 | Switches |
| 6 | Ceramic capacitors |
| 7 | Midpoint of ceramic capacitors |
| 9 | Connection point between the low side switch 4 and the high side switch 5 |
| 10 | Half bridge power board |
| 11 | Vias |
| 12 | Ceramic capacitors close to DC bus of 14 |
| 14 | Power switching device |
| 15 | Driver |
| 16 | Board connector |
| 17 | Midpoint of ceramic capacitors |
| 18 | Power pins |
| 19 | Connection copper trace between power switches 4,5 |
| 20 | Gate trace of high side Mosfet 14a |
| 21 | Kelvin source trace of high side Mosfet 14a |
| 30 | Elasting retaining clip |
| 31 | Snap-in mounting of 30 |
| 32 | Insulation sheath (heat-shrink tubing) |
| 33 | Thermal pad |
| 50 | Heat sink |
| 51 | Cooling fins of 50 |
| 52 | Recess in 50 |
| 70 | Mother master board |

**Detailed description**

Throughout the present description, the term « switch » includes a relay, i.e. an electrically operated switch.

Figure 2 show views of a the two-layer half-bridge PCB power board, in accordance with some exemplary embodiments of the invention.

Figure 2a shows a top view of the two-layer PCB power board **10** comprising two MOSFETs **14a,14b.** It also comprises a set of ceramic DC bus components **12a,12b.**

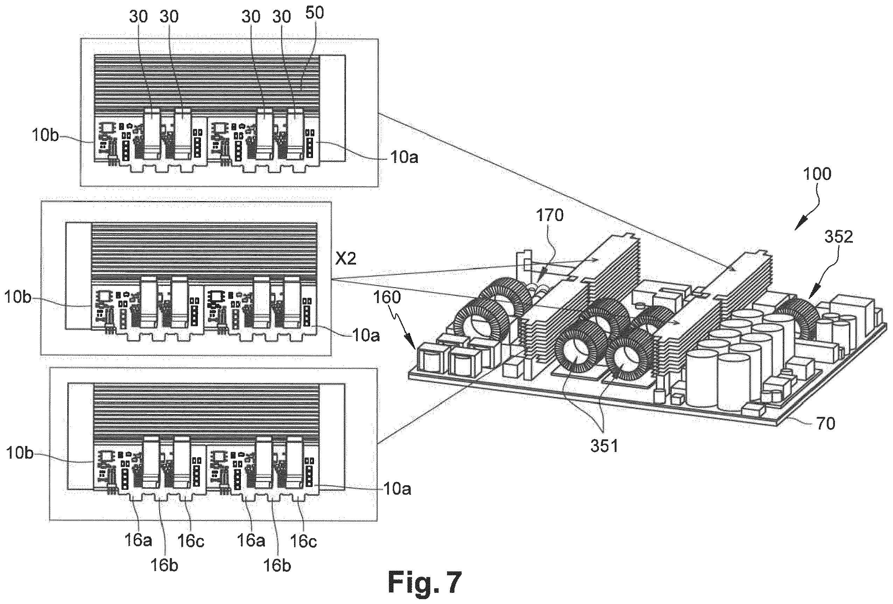

This daughter board **10** is designed to connect to a main board (visible on figure 7) via a set of six power pins **18** and three board connectors **16a,16b,16c.** A flat thermal pad **33** with high thermal conductivity is placed at the flat back side of the PCB **10** to help achieve the lowest possible thermal resistance and provide electrical insulation to the system. Said thermal pad **33** is a flat portion of a larger heat sink **50,** as will be shown below.

Figure 2b and Figure 2c show schematic drawings the top copper layer (figure 2b) and the bottom copper layer (figure 2c) of the two-layers PCB power board of figure 2a. Figure 2d shows a superposition of figures 2b and 2c. The two copper layers separated by an insulating layer. The current passes from the top layer to the bottom layer and flows in a loop between the two layers, the bottom layer being used for the current return. This current corresponds to the high frequency component of $I_{load}$ on figure 1. The two layers structure minimises the size of the loop and, as a result, minimises the induced magnetic field.

The figures shows a plurality of thermal vias **11** under the switching devices **14** that help draining the heat out of the board **10.** The thermal vias **11** comprise through holes drilled from the top to the bottom of the PCB **10.** The thermal vias should cover maximum area under the MOSFET cases **14a,14b.** Their drilled diameter can be for instance 0.008 inch (about 200 $\mu$m) or 0.010 inch (abour 254 $\mu$m) or more generally between about 100 $\mu$m and about 400 $\mu$m. The via wall is plated (typically copper-plated), the plating may be for instance 20 $\mu$m thick (0.0008 inches, according to IPC class 2 plating) or 25 $\mu$m thick (0.0010 inches, IPC class 3 plating).

On this two-layer PCB board the return power path is placed on the bottom layer to minimize power-loop inductance. Due to the thermal vias, the current return cannot perfectly mirror the current path located on the top layer. To still have the lowest loop inductance, the power devices **14** are located as close together as possible, and the ceramic capacitors **12a,12b** (which are in parallel with $V_{DC}$, see figure 1) are as close as possible to the DC bus of said power devices **14** and are split into two equal groups positioned the closest to each power switch. The midpoint **17** connects the two sets of capacitors **12a,12b.**

The distance *d* between midpoint **17** connecting the two sets of ceramic capacitors **12a,12b** and the power switches **14a,14b** is minimized. The distance is at least equal to the minimum creepage distance given by the safety standards for a maximum voltage value of DC bus voltage divided by 2. For example for a DC bus voltage of 850 V, the voltage between said mid-point (17) and said power swiches is 425 V. Standard IEC 60664-1 specifies that a minimum distance of 1.08 mm should be repsected. In this example, a distance of d = 1.25 mm was chosen.

This distance e between the copper traces between two adjacent power switches should be small and can be typically comprised between about 1 mm and about 3 mm to be able to pass the gate **20** and kelvin-source traces **21** to the driver **15** at the upper part of the board.

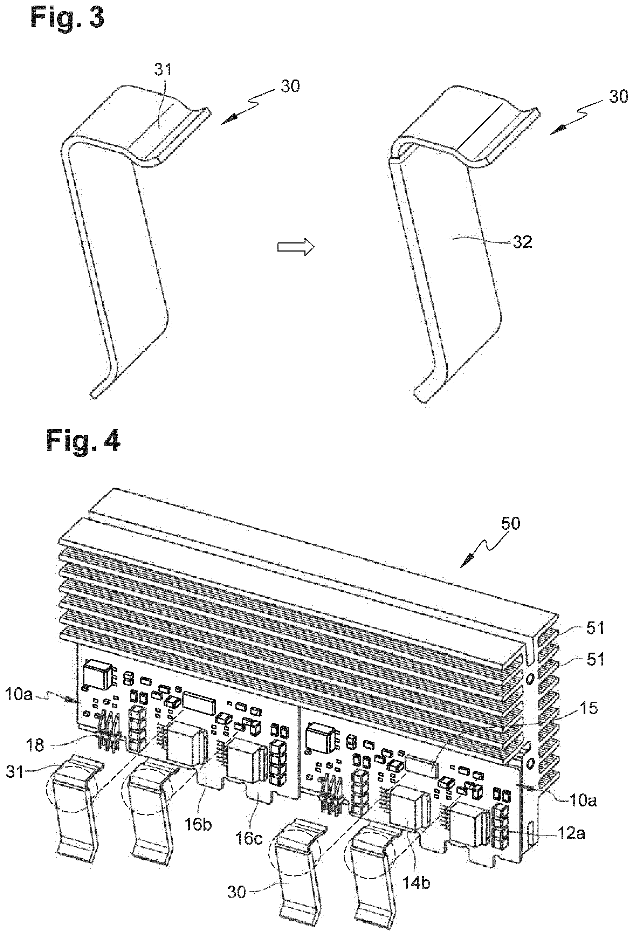

Figure 3 shows the elastic retaining clip **30** in accordance with some exemplary embodiments of the invention. According to the invention, the clip **30** is used for fixing the heat sink (not shown in the figure) to the half bridge power board (not shown in the figure). Clip **30** is a standard, off-the shelf retaining clip with snap-in mounting **31.** In an advantageous embodiment, the portions of said retaining clips **30** which are not in contact with the heat sink are isolated with an insulation sheath **32,** which can be flame retardant heat shrink tubing **32** having adequate dielectric withstand voltage.

Both said retaining clips **30** and said heat shrinking tubing **32** are inexpensive standard components used in electrical engineering. Such a clip is typically used with through hole MOSFET package and is widely available in various shapes and sizes. According to some embodiments the clip is rounded and elastic. These clips allow to apply high pressure force onto a large fraction of the surface of a power switching component, which leads to higher power dissipation. Said retaining clips **30** are easy to mount and can be removed for repair work without damaging the PCB or its components. This is another advantage of the present invention.

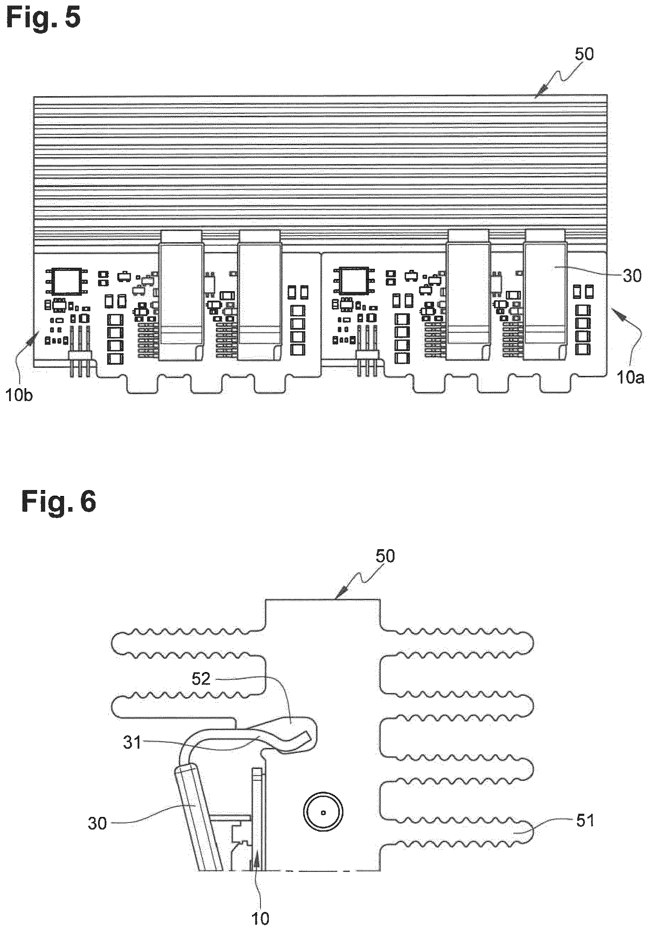

Figures 4 and 5 illustrate an embodiment in which two inverter/rectifier legs according to the invention, each on its own PCB board **10a,10b,** are mounted on one heat sink **50,** using two pairs of retaining clips **30** which exert mechanical pressure on the MOSFETs **14.**

Figure 4 shows the two-layers PCB power boards **10a,10b** witth the elastic retaining clips **30** to be positioned. One clip **30** is used for each power switching component **14.**

Figure 5 shows the two-layers PCB power board **10** with the mounted retaining clips **30** in accordance with some exemplary embodiments of the invention. As can be seen by comparison between figure 4 and figure 5, each elastic retaining clip **30** exerts pressure on the power switching component **14** onto which it is mounted, thereby pressing the PCB board **10** against the flat thermal pad **33** of the heat sink **50.**

Figure 6 represent a cross-sectional view of a heat sink **50** with a PCB board **10** attached to its flat surface **33** by using an elastic retaining clip **30** in accordance with another exemplary embodiments of the invention. The figure shows the snap-in **31** of the elastic retaining clips **30** that extends into a recess **52** of the heat-sink **50**.

Figure 7 shows a battery charger for electrical vehicles, comprising a mother master board **70** provided with four sets of two vertical daughter boards **10a,10b** according to the invention, connected to said mother master board **70** using vertical board connectors **16a,16b,16c.** Said daughter boards **10a,10b** are similar to those shown on figure 4; two of these daughter boards **10a,10b** are fixed onto one heat sink **50** using a set of elastic retaining clips **30** that exert pressure onto the power switching devices **14.**

According to an advantageous embodiment, the PCB daughter board **10** is a FR-4 PCB and/or an Insulated Metal Substrate (IMS) board. In some embodiments the two-layers PCB power board is designed to work with fast power switching components that are selected among TO-263-7 (D2PAK-7) MOSFETs. In some embodiments the two-layers PCB power board includes two MOSFETs and all necessary circuits, including isolated gate driver, negative bias, and temperature measurement.

In an exemplary embodiment of the invention, PCB powerboards **10** with two MOSFETs operating at 650 V and 1200 V, respectively, have been used in a universal battery charger for electrical vehicles; figure 7 identifies further essential components of this battery charger, namely an input AC filter **160,** an output DC filter **352,** a set of boost inductors being part of a DC/DC converter **351,** and an ID detection and reconfiguration system **170** comprising switches (not shown on the figures).

More generally, for a dc bus voltage of $V_{dc}$ (see figure 1) and a MOSFET voltage rating of $V_{ds}$max, the maximum allowed voltage overshoot should not exceed:

$$\Delta V = (V_{ds}max * safetymargin - V_{dc}).$$

The safety margin factor (safetymargin) is usually selected between 0.75 and 0.9 ; a typical value is 0.8.

On the other hand, we can write: $\Delta V \approx L_{stray} * I_{load} / \Delta t$ where $\Delta t$ is the fall time of the drain current $I_{Q2}$ (or $I_{Q1}$). Therefore $L_{stray}$ should be strictly lower than

$$\Delta V * \Delta t / I_{load} = (V_{ds}max * safetymargin - V_{dc}) * \Delta t / I_{load}.$$

For example for $I_{load}$ = 30 A, $V_{dc}$ = 850 V, $V_{ds}$max = 1200 V, safetymargin = 0.8 and $\Delta t$ = 10 ns (this is a typical value for SiC MOSFETs), $\Delta V$ should be lower than 110 V and $L_{stray}$ should be lower than 40 nH, and preferably lower than 30 nH.

For a device including a two-layer PCB power board for use in a power conversion unit for charging the battery of a electrical vehicle from the grid according to the present invention as described above, the inventors have determined a value for $L_{stray}$ of 18 nH.

We will here briefly described how the stray inductance $L_{stray}$ can be determined on such a two-layer PCB power board. Since the parasitic inductance is of the order of magnitude of a few nano-Henry, the stray inductance $L_{stray}$ can be deduced by measuring the resonance frequency of the voltage oscillations of $V_{Q1}$ or $V_{Q2}$ (see figure 1). In order to make the stray inductance measurement independent of the uncertain capacitance values, an extremely stable capacitor which is not affected by temperature, applied voltage, or aging can be added in parallel to Q1 (if $V_{Q1}$ is to be measured) or Q2 (if $V_{Q2}$ is to be measured). The added capacitor should have a value much higher than MOSFET output capacitance.

Figure 8 shows the universal battery **100** according to the invention, configured as a charger in a three-phase mode used to charge a vehicle battery, in accordance with some exemplary embodiments of the subject matter.

Charger **100** comprises four current lines referenced here as N1,N2,N3,N4. It comprises a first set of electrical connectors **101,102,103,104,** intended to be connected to the grid, and a second set of electrical connectors **153,154** intended to be connected to the battery of an electric vehicle.

Charger **100** further comprises an AC/DC converter **150,** and for each current line N1,N2,N3,N4 a set of filters **160,** said set of filters typically comprising a common mode filter **161** (which can be an inductance with a magnetic core) and a differential inductance **162.** Such a set of filters is known as such, and the same applies to the AC/DC converter **150.** Said AD/AC converter **150** typically uses fast power switching devices such as SiC MOSFETs, operating at high voltage as mentioned above, with a switching time of the order of 10 ns. These fast power switching devices carry current in the order of 10 A to 25 A; they require therefore very efficient cooling, and their switching will induce magnetic fields which should be minimized by approprate PCB board design according to the invention, as explained above.

Typically, all connectors of the first set of connectors form a first connector unit **190,** and/or all connectors of the second set of connectors form a second connector unit **191.** Said first connector unit **190** comprises connectors **101, 102, 103, 104** labelled here respectively as L1, L2, L3 and L4. In the three-phase operation shown in figure 8, L1 connector **101** of charger **100** is connected to R connector **106** of the grid; L2 connector **102** is connected to S connector **107;** L3 connector **103** is connected to T connector **108,** and L4 connector **104** is connected to N connector **109,** and said connectors L1, L2, L3 and L4 are intended to be connected to grid connectors R **106,** S **107,** T **108** and N **109,** N being the neutral. Said grid connector R **106** is connected to grid line **110,** and said grid connectors S **107** is connected to grid line **111,** and said grid connector T **108** is connected to grid line **112.** Said grid line N **109** is the neutral **113** of the grid, which can be connected to protective earth PE **105.**

As can be seen on figure 8, in the three-phase operation when the charger is connected to the grid: Grid line **110** is connected to R connector **106** which connected to L1 connector **101.** Said L1 connector **101** is connected to current line N1 via a switch (not shown in the figure); said current line N1 is connected to filter line **114** which is connected to said AC/DC converter **150.** Grid line **111** is connected to S connector **107** which is connected to L2 connector **102.** Said L2 connector **102** is connected to current line N2 via a switch (not shown in the figure); said current line N2 is connected to filter line **115** which is connected to said AC/DC converter **150.** Grid line **112** is connected to T connector **108** which is connected to L3 connector **103.** Said L3 connector **103** is connected to current line N3 via a switch (not shown in the figure); said current line N3 is connected to filter line **116** which is connected to said AC/DC converter **150.** Grid connector **109** is connected via grid line **113** to protective earth **105,** and is connected to L4 connector **104** which is connected to current line N4 via a switch (not shown in the figure); said current line N4 is connected to filter line **117** which is connected to AC/DC converter **150.** Each of said filter lines **114,115,116,117** runs through each of the filters **161,162** of the set of filters **160.** Said for swiches (not shown on the figures) form part of the ID detection and reconfiguration system **170** (also called « configurator »).

The AC/DC converter **150** is connected to the battery (not shown in the figures) via connector **153** and connector **154.**

Typically all grid connectors R,S,T,N form part of a connector unit, referenced here as to the « third » connector unit **193.** Said third connector unit **193** is typically provided by the operator of the charging station. Said first connector unit **190** is designed to be connected, directly or via a suitable adapter unit (not shown on the figures), to said third connector unit **193.**

According to an advantageous embodiment the three-phase state configuration described herein is set by a configurator **170** (the structure of which is not shown in this figure) using said set of switches. It should be noted that in this figure, as in all other figures of this description, dotted current lines indicate the optional presence of additional components.

The universal and versatile charger **100** for electric battery shown in figure 8 can be configured differently by means of configurator **170** (the structure of which will be explained below) using a set of switches ; as an example, the three-phase mode can be switched to the single-phase mode, and vice versa.

Figure 9 shows the universal and versatile charger **300** for electric battery in accordance to another exemplary embodiment of the present invention. All reference numbers of features that are common with those in figure 8 have been increased by 200. The charger operates here in a four-phase configuration. In this embodiment the first connector unit **390** has a different structure from the one depicted on figures 8. Furthermore, the charger **300** is provided with a DC/DC converter **351** in addition to the AC/DC converter **350.**

The first connector unit **390** comprises six connectors, five of which are intended to be connected to grid connectors when the device **300** is used as a charger in four-phase operation mode. The peculiar feature of this embodiment (which is compatible with all embodiments of the present invention) is the presence of a signal line ID, which will be explained below. An adapter unit **380** is used for connecting the first connector unit **390** to the grid; the third connector unit with grid connectors is not shown on this figure.

Each connector **301,302,303,304,305,326** of the first connector unit **390** has a corresponding connector **331,332,333,334,335,336** on the charger-side of the adapter **380:** the L1 connector 301 matches connector **331,** L2 connector **302** matches connector **332,** L3 connector **303** matches connector **333,** L4 connector **304** matches connector **334,** PE connector **305** matches connector **336,** and ID connector **326** matches connector **336.** The grid side of adapter **380** has corresponding connectors: L1 connector **331** is connected to grid line R **306,** L2 connector **332** is connected to grid line S **307,** L3 connector **333** is connected to grid line T **308,** L4 connector **334** is connected to grid line N **309,** PE connector **321** is connected to the protective earch PE **321.**

The configuration of the charger **300** is set by switches comprised in the configurator **370.** Said configurator **370** is controlled by a digital signal processor (DSP) **365** which includes a microprocessor. Said DSP **365** also receives data from the the configurator **370** and from the AC/DC converter **350** and/or the DC/DC converter **351.** This bidirectional communication link for digital data transfer is symbolized on figure 9 by dotted lines with arrows.

The DSP **365** senses the voltage signal ID derived from the protective earth PE via resistance **323,** and is configured to recognize the configuration of the grid when the charger is connected to the grid. It will then configure the configurator **370** accordingly, by sending appropriate instructions to the switches of the configurator **390.** Furthermore, the DSP **365** is configured such that when the user selects the vehicle-to-load (V2L) mode, the DSP **365** will instruct the configurator **370** to configure the circuits accordingly, using switches; this will be described below in relation with figure 10. External resistance **323** can be incorporated in the AC cable or in the adapter, or added externally by the user.

The ID detection and reconfiguration unit **370** automatically recognizes the grid configuration (such as: four-phase, three-phase with/without neutral, bi-phase, single-phase). It also allows to set the charger to a V2L configuration. This will be explained in greater details in relation with figure 10.

Figure 10 shows is a detailed view of the ID detection and reconfiguration **370,470** of a universal charger **300** for electric battery in accordance to another exemplary embodiment of the present invention. All reference numbers of features that are common with those in figure 8 have been increased by 200 or 300. The charger operates here in a four-phase configuration. In this embodiment the first connector unit **390** has a different structure from the one depicted on figure 8. Furthermore, the charger **300** is provided with a DC/DC converter **351** in addition to the AC/DC converter **350**.

The configurator **470** comprises a first switching unit **471,** a second switching unit **472,** and a third switching unit **476**. The switches of each of these switching units can advantageously be formed by two independent relays (preferably so-callled 1Form A relays with a default state of normally open) operated simultaneously, or by one single relay of the 2 Form A type (this terminology being known to a person skilled in the art of electrical engineering).

Said first switching unit **471** comprises two switches **471a,471b**. They are closed in case of charging in single-phase mode ; this allows to charge up to two third of the nominal three-phase mode power, thereby allowing the reduction of the charging time by half compared to the state of the art. In other operating modes switches **471a,471b** are open.

Said third switching unit **476** is optional. It comprises two switching subunits **477,478,** each of which comprises two switches **477a,477b;478a,478b**. These switching subunits **477,478** are pre-charge relays used for passive precharge of the DC bus capacitors. Once the precharge is done, these relays can be opened.

Said second switching unit **472** comprises three switching subunits **473,474,475**. The first **473** and second **474** switching subunits are main AC relays. They are closed in case of charging in the single-phase or three-phase mode once the pre-charge is over. The first switching unit **473** comprises two switches **473a;473b**. The third switching subunit **475** is only closed in single-phase mode charging or in the case of three-phase mode charging with neutral. However, it is preferred that in case of unbalanced three-phase systems with neutral, when the charger is connected to the AC grid, switch **475** be openend to force the homopolar (or zero sequence) current to zero.

Resistors **479** between the first **471** and second **472** switching unit are so-called « precharge resistors », known as such. Their function is to precharge the capacitive elements, in order to avoid a peak of inrush current; such a peak inrush current could be capable of damaging switches, input capacitors, fuses and battery cells.

The connectors L1 **401**, L2 **402**, L3 **403**, L4 **404**, PE **405** as well as the connector for the ID cable **426** are configured to be connectable to a six pins AC connector **490**. Said AC connector **490** allows to connect:

- the L1 connector **401** via current line **431** to the R connector **406** of the grid,
- the L2 connector **402** via current line **432** to the S connector **407** of the grid,
- the L3 connector **403** via current line **433** to the T connector **408** of the grid,
- the L4 connector **404** via current line **434** to the N connector **409** of the grid,
- the PE connector **405** via current line **435** to the protective earth **421** of the grid.

The ID connector **426** is connected via current line **436** in series to an external resistance **423** that connects in parallel with the protective earth **421** of the grid. The manufacturer of the charger specifies to the user the value of the external resistance **423** to be added for each operation mode.

As can be seen from figure 7, certain components of the charger **100** according to the invention (such as input AC filters **160** and DC/DC convertes **351**) can be rather bulky and can be arranged on a mother PCB board **70,** while the fast power switching components **14** of the AD/DC converter must be arranged on a multiple-layer PCB board according to the invention that is connected to a heat sink **50**. Said multiple-layer PCB board **10** comprising at least one two-switch leg structure comprising power switching components **14** according to the invention has several other uses, and the power conversion unit described above is a specific embodiment that does not limit the scope of the invention.

An PCB power board (10) according to the invention that is particularly advantageous for use in a battery charger for charging the batteries of an electrical vehicle is characterized in that

(i) the maximum DC voltage of at least one of said power switching components (14) is comprised between 400 V and 900 V and for a maximum current comprised between 10 A and 50 A, and preferably between 15 A and 40 A, and still more preferably between 20 A and 35 A, and the stray inductance is below 40 nH, preferably below 30 nH, and still more preferably below 20 nH; and/or

(ii) the maximum DC voltage of at least one of said power switching components (14) is comprised between 200 V and 500 V and for a maximum current comprised between 10 A and 50 A, and preferably between 15 A and 40 A, and still more preferably between 20 A and 35 A, and the stray inductance is below 35 nH, preferably below 25 nH, and still more preferably below 15 nH.

This can be achieved by the design principles described above, in particular by using a multiple layer PCB board and by minimizing the distances e and/or d. These power boards will generate much heat, and should therefore be connected in a thermally efficient way to a heat sink, using a flat portion of said PCB board and, preferably, elastic retaining clips, as described above.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

**Claims**

1. A multiple layer PCB power board (10) comprising at least one two-switch leg structure comprising power switching components (14) and associated driving circuits, **characterised in that** said board is configured such that the current flows from a top layer to a bottom layer, to minimize power-loop inductance.

2. PCB power board (10) according to claim 1, **characterized in that** said board comprises ceramic capacitors (12) in parallel with said power switching components (14), and is configured such that the distance d between the mid point (17) of said capacitors (12a,12b) and said power switching components (14) is minimized, to minimize power-loop inductance.

3. PCB power board (10) according to any of claims 1 or 2, **characterised in that** said board comprises ceramic capacitors (12) in parallel with said power switching components (14), and is configured such that the distance d between the mid point (17) of said capacitors (12a,12b) and said power switching components (14) is comprised between 1.1 mm and 2.5 mm, and preferably comprised between 1.1 mm and 2.0 mm, and still preferably between 1.1 mm and 1.5 mm, for a maximum DC bus voltage not exceeding 900 V.

4. PCB power board (10) according to any of claims 1 to 3, **characterised in that** said PCB power board comprises ceramic capacitors (12) in parallel with said power switching components (14), and is configured such that the distance e between the copper traces between two adjacent power switches (14a,14b) is comprised between 1.0 mm and 3.0 mm, and preferably between 1.0 mm and 2.0 mm.

5. PCB power board (10) according to any of claims 1 to 4, **characterized in that**

    (i) the maximum DC voltage of at least one of said power switching components (14) is comprised between 400 V and 900 V and for a maximum current comprised between 10 A and 50 A, and preferably between 15 A and 40 A, and still more preferably between 20 A and 35 A, and the stray inductance is below 40 nH, preferably below 30 nH, and still more preferably below 20 nH; and/or
    (ii) the maximum DC voltage of at least one of said power switching components (14) is comprised between 200 V and 500 V and for a maximum current comprised between 10 A and 50 A, and preferably between 15 A and 40 A, and still more preferably between 20 A and 35 A, and the stray inductance is below 35 nH, preferably below 25 nH, and still more preferably below 15 nH.

6. PCB power board (10) according to any of claims 1 to 5, intended to be connected to a heat sink (50), caracterized in that said PCB power board (10) has a bottom side provided with a flat portion that is designed to be connected to a flat thermal pad (32) which is part of said heat sink (50).

7. PCB power board according to claim 6 connected to a heat sink (50), wherein said PCB power board is connected to said heat sink (50) by means of at least one elastic retaining clip (30).

8. PCB power board according to claim 7, wherein said at least one elastic retaining clip (20) exerts mechanical pressure onto at least one of said power switching components (14), said mechanical pressure being directed towards said flat thermal pad (32).

9. PCB power board according to any of claim 7 or 8, wherein each of said power switching components (14) is mechanically pressed towards the PCB board by one of said elastic retaining clips (30).

**10.** Use of a PCB power board according to any of claims 1 to 9 in a power conversion unit.

**11.** Power conversion unit comprising at least one PCB board according to any of claims 1 to 10.

**12.** Power conversion unit (100,300,400) according to claim 11 for charging the battery of an electric vehicle from the grid, comprising :

- a first connector unit (190,390) for connecting the charger to the grid,
- an AC/DC converter (150) comprising fast power switching components (14),
- a set of filters (160) provided between said first connector unit (190) and said AC/DC converter (150),
- a second connector unit (191) for connecting the charger to the battery,
- a configurator (170,470) provided with a set of switches and/or relays capable of switching between a three-phase operation and a single-phase operation for charging said battery from the grid, said configurator being provided between said first connector unit (190) and said set of filters (160), wherein at least said AC/DC converter (150) is arranged on a mulitple layer PCB power board according to any of claims 1 to 5.

**13.** A power conversion unit according to claim 12, **characterized in that** said configurator (170,470) is provided with a detection system configured to detect the grid configuration, and in particular to identify a single-phase grid configuration and a three-phase grid configuration, and preferably also a two-phase grid configuration.

**14.** A power conversion unit according to claim 11 or 12, **characterized in that** said configurator (170,470) is provided with a system to configure said set of switches according to the grid configuration detected by said detection system.

**15.** A power conversion unit according to any of claims 12 to 14, further comprising a DC/DC converter (351) provided between said AC/DC converter (350) and said second connector unit (191).

# Fig. 1

# Fig. 2a

# Fig. 2b

# Fig. 2c

# Fig. 2d

**Fig. 3**

**Fig. 4**

## Fig. 5

## Fig. 6

Fig. 7

EP 4 131 759 A1

**Fig. 8**

EP 4 131 759 A1

**Fig. 9**

EP 4 131 759 A1

# Fig. 10

Europäisches
Patentamt

European
Patent Office

Office européen
des brevets

# EUROPEAN SEARCH REPORT

Application Number

EP 21 18 9457

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/183550 A1 (REUSCH DAVID [US] ET AL) 3 July 2014 (2014-07-03)<br>* paragraph [0007]; figures 4-6,13-20 *<br>* paragraph [0013] – paragraph [0015] *<br>* paragraph [0043] *<br>* paragraph [0046] *<br>* paragraph [0050] *<br>----- | 1-5,10, 11 | INV.<br>H02M3/00<br>H02M7/00 |
| X | US 2018/226886 A1 (FÜRST JOHANNES [DE] ET AL) 9 August 2018 (2018-08-09)<br>* paragraph [0007]; figures 1,10-12 *<br>* paragraph [0011] – paragraph [0012] *<br>* paragraph [0015] *<br>* paragraph [0020] – paragraph [0021] *<br>* paragraph [0024] *<br>* paragraph [0054] – paragraph [0055] *<br>* paragraph [0062] *<br>----- | 1,10,11 | |
| X | US 2020/288562 A1 (OKAGAWA YUUSUKE [JP]) 10 September 2020 (2020-09-10)<br>* paragraph [0056] – paragraph [0064]; figures 1,5,6,7 *<br>----- | 1,6-11 | |

**TECHNICAL FIELDS SEARCHED (IPC)**

H02M

The present search report has been drawn up for all claims

| Place of search | Date of completion of the search | Examiner |
|---|---|---|
| The Hague | 18 January 2022 | Gusia, Sorin |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**Application Number**

**EP 21 18 9457**

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

**see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

**1-11**

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 21 18 9457

The Search Division considers that the present European patent application does not comply with the requirements of unity of invention and relates to several inventions or groups of inventions, namely:

      **1. claims: 1-11**

            **Multiple layer PCB with connection to a heat sink**
                        ---

      **2. claims: 12-15**

            **Power conversion unit with single-phase/three-phase
operation configurator**
                        ---

## ANNEX TO THE EUROPEAN SEARCH REPORT
## ON EUROPEAN PATENT APPLICATION NO.

EP 21 18 9457

This annex lists the patent family members relating to the patent documents cited in the above-mentioned European search report.
The members are as contained in the European Patent Office EDP file on
The European Patent Office is in no way liable for these particulars which are merely given for the purpose of information.

18-01-2022

| Patent document cited in search report | | Publication date | Patent family member(s) | | Publication date |
|---|---|---|---|---|---|
| US 2014183550 | A1 | 03-07-2014 | CN | 105075405 A | 18-11-2015 |
| | | | DE | 112013006313 T5 | 24-09-2015 |
| | | | JP | 6371309 B2 | 08-08-2018 |
| | | | JP | 2016503963 A | 08-02-2016 |
| | | | KR | 20150102983 A | 09-09-2015 |
| | | | TW | 201444055 A | 16-11-2014 |
| | | | US | 2014183550 A1 | 03-07-2014 |
| | | | WO | 2014105887 A1 | 03-07-2014 |
| US 2018226886 | A1 | 09-08-2018 | CN | 108400716 A | 14-08-2018 |
| | | | EP | 3361836 A1 | 15-08-2018 |
| | | | JP | 6709810 B2 | 17-06-2020 |
| | | | JP | 2018130015 A | 16-08-2018 |
| | | | US | 2018226886 A1 | 09-08-2018 |
| US 2020288562 | A1 | 10-09-2020 | CN | 111357182 A | 30-06-2020 |
| | | | DE | 112018005338 T5 | 25-06-2020 |
| | | | JP | WO2019092926 A1 | 26-11-2020 |
| | | | US | 2020288562 A1 | 10-09-2020 |
| | | | WO | 2019092926 A1 | 16-05-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Modular approach to power electronics. **URBAN MEDIC.** White Paper. Infineon, March 2019

- **TEXAS INSTRUMENTS.** Using the LMG3410-HB-EVM Half-Bridge and LMG34XX-BB-EVM Breakout Board EVM - General TI High Voltage Evaluation User Safety Guidelines. April 2016